# EUROPEAN PATENT APPLICATION

(11) **EP 4 258 355 A1**
(43) Date of publication of application: **11.10.2023**
(21) Application number: 21900291.2
(22) Date of filing: 08.10.2021
(51) Int. Cl.: H01L 27/146, H01L 23/02, H01L 23/29, H01L 23/31, H04N 5/359

(54) **SEMICONDUCTOR MODULE AND METHOD FOR MANUFACTURING SAME**

(30) Priority: 03.12.2020 JP 2020200816
(71) Applicant: Sony Semiconductor Solutions Corporation, Atsugi-shi, Kanagawa 243-0014 (JP)
(72) Inventor: TSUKADA, Atsushi, Atsugi-shi, Kanagawa 243-0014 (JP); MAKINO, Hirofumi, Atsugi-shi, Kanagawa 243-0014 (JP); IGARASHI, Koichi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2021/037355
(87) International publication number: WO 2022/118535

(57) **Abstract**

To prevent unnecessary light ray reflection in a semiconductor module employing a chip-on-chip structure or a chip-on-wafer structure.

The semiconductor module includes a substrate, first and second semiconductor elements, and a cover part. The first semiconductor element is arranged on the substrate. The first semiconductor element includes a wiring electrically connected to the substrate and a pixel region of an imaging element on an upper surface opposite to a surface facing the substrate. The second semiconductor element is arranged at a position different from the pixel region on the upper surface of the first semiconductor element. The cover part covers the first and second semiconductor elements from the upper surface with respect to at least a part of a region excluding the pixel region.

## Description

### TECHNICAL FIELD

The present technology relates to a semiconductor module. Specifically, the present invention relates to a semiconductor module including an imaging element and a method for manufacturing the same.

### BACKGROUND ART

In a semiconductor module including an imaging element, in order to prevent occurrence of flare and ghost due to reflection of unnecessary light rays, there is known a technique of shielding light in portions other than a pixel region. For example, a package has been proposed in which a protective substrate is provided via a spacer material on a substrate on which a sensor is formed (see, for example, Patent Document 1).

### CITATION LIST

### PATENT DOCUMENT

Patent Document 1: Japanese Patent Application Laid-Open No. 2018-050054

### SUMMARY OF THE INVENTION

### PROBLEMS TO BE SOLVED BY THE INVENTION

In the above-described conventional technique, a sensor window opening is provided in the protective substrate so as to shield light on other portions. However, in a case where a chip-on-chip structure or a chip-on-wafer structure is employed, a functional component such as a logic chip is arranged around a pixel region, in which light rays are reflected from the functional component, and flare or ghost may occur. Thus, it may be necessary to further prevent light ray reflection from the functional component.

The present technology has been made in view of such a situation, and an object thereof is to prevent unnecessary light ray reflection in a semiconductor module employing a chip-on-chip structure or a chip-on-wafer structure.

### SOLUTIONS TO PROBLEMS

The present technology has been made to solve the above-described problems, and a first aspect thereof is a semiconductor module including a substrate, a first semiconductor element arranged on the substrate and including a wiring electrically connected to the substrate and a pixel region of an imaging element on an upper surface opposite to a surface facing the substrate, a second semiconductor element arranged at a position different from the pixel region on the upper surface of the first semiconductor element, and a cover part that covers the first and second semiconductor elements from the upper surface with respect to at least a part of a region excluding the pixel region, and a method for manufacturing the same. Thus, by covering the second semiconductor element arranged on the first semiconductor element with the cover part, an effect of preventing unnecessary light ray reflection is produced.

Furthermore, in the first aspect, the cover part may be a frame having an opening corresponding to the pixel region and is attached to the substrate so as to cover the first and second semiconductor elements from the upper surface. Thus, the effect of preventing unnecessary light ray reflection is produced without preventing light from entering the pixel region. Furthermore, in this case, the frame may be formed by resin or metal.

Furthermore, in the first aspect, the frame may have a hollow structure with respect to a region including the second semiconductor element and the wiring. In addition, in this case, a filling portion filled in a sealed manner in a region including the second semiconductor element and the wiring may be further included. At that time, the filling portion may be formed by resin.

Furthermore, in the first aspect, the frame may be in contact with the upper surface of the second semiconductor element. Thus, by blocking the upper surface of the second semiconductor element, an effect of preventing reflected light is produced.

Furthermore, in the first aspect, the frame may be embossed on an inner wall facing the pixel region. Thus, an effect of suppressing reflected light from being incident on the pixel region is produced.

Furthermore, in the first aspect, the frame may have a tapered structure in which an inner wall facing the pixel region is inclined toward the pixel region. Thus, the effect of suppressing reflected light from being incident on the pixel region is produced.

Furthermore, in the first aspect, a sealing glass bonded to an upper surface of the frame via a sealing material may be further included. In this case, the frame may include a recess in a region in contact with the sealing glass in an inner wall facing the pixel region. Thus, an effect of preventing reflection of a light ray caused by the light ray hitting the frame is produced.

Furthermore, in the first aspect, the cover part may be a sealing resin that seals a portion other than an opening corresponding to the pixel region. Thus, an effect of miniaturization and height reduction of the semiconductor module is produced. In this case, a sealing glass bonded to an upper surface of the sealing resin via a sealing material may be further included. Furthermore, a transparent resin may be further included in the opening.

Furthermore, in the first aspect, the cover part may be a molding resin that covers a back surface and a side surface of the second semiconductor element. Thus, an effect of preventing reflected light from the second semiconductor element is produced. In this case, the molding resin contains a filler. Furthermore, the second semiconductor element may be bonded to the first semiconductor element via an underfill, and a fillet of the underfill may be located outside the molding resin.

Furthermore, in the first aspect, each of the first and second semiconductor elements may be a semiconductor chip, and may form a chip-on-chip structure. Furthermore, the first semiconductor element may be a semiconductor wafer, the second semiconductor element may be a semiconductor chip, and the first and second semiconductor elements may form a chip-on-wafer structure.

### BRIEF DESCRIPTION OF DRAWINGS

Fig. 1 is a view illustrating an example of a relationship between an image sensor chip 100 and logic chips 200 according to an embodiment of the present technology.
Fig. 2 is a view illustrating an example of a top view of a semiconductor module according to the embodiment of the present technology.
Fig. 3 is a view illustrating an example of a cross-sectional structure of a semiconductor module according to a first embodiment of the present technology.
Fig. 4 is a view illustrating an example of a resin reservoir 401 of a frame 400 according to the first embodiment of the present technology.
Fig. 5 is a view illustrating an example of embossing 402 of an inner wall of the frame 400 according to the first embodiment of the present technology.
Fig. 6 is a view illustrating an example of a tapered structure 403 of the inner wall of the frame 400 according to the first embodiment of the present technology.
Fig. 7 is a view illustrating an example of a cross-sectional structure of a semiconductor module according to a second embodiment of the present technology.
Fig. 8 is a first view illustrating an example of a method for manufacturing the semiconductor module according to the second embodiment of the present technology.
Fig. 9 is a second view illustrating an example of the method for manufacturing the semiconductor module according to the second embodiment of the present technology.
Fig. 10 is a view illustrating an example of a cross-sectional structure of a semiconductor module according to a third embodiment of the present technology.
Fig. 11 is a view illustrating an example of a cross-sectional structure of a semiconductor module according to a fourth embodiment of the present technology.
Fig. 12 is a view illustrating an example of a cross-sectional structure of a semiconductor module according to a fifth embodiment of the present technology.
Fig. 13 is a first view illustrating an example of a method for manufacturing the semiconductor module according to the fifth embodiment of the present technology.
Fig. 14 is a second view illustrating an example of the method for manufacturing the semiconductor module according to the fifth embodiment of the present technology.
Fig. 15 is a view illustrating an example of a cross-sectional structure of a semiconductor module according to a sixth embodiment of the present technology.
Fig. 16 is a view illustrating an example of a method for manufacturing the semiconductor module according to the sixth embodiment of the present technology.
Fig. 17 is a view illustrating an example of a cross-sectional structure of a semiconductor module according to a seventh embodiment of the present technology.
Fig. 18 is a view illustrating an example of a process of manufacturing the semiconductor module according to the seventh embodiment of the present technology.
Fig. 19 is a view illustrating an appearance example of logic chips 820 after microbumps 209 are formed according to the seventh embodiment of the present technology.
Fig. 20 is a view illustrating an example of how logic chips 200 are singulated according to the seventh embodiment of the present technology.
Fig. 21 is a view illustrating an example of a state of arrangement of the logic chips 200 on a temporary arrangement sheet 830 according to the seventh embodiment of the present technology.
Fig. 22 is a view illustrating an example of a state of forming a molding resin 470 according to the seventh embodiment of the present technology.
Fig. 23 is a view illustrating an example of how the logic chips 200 covered with the molding resin 470 are singulated according to the seventh embodiment of the present technology.
Fig. 24 is a view illustrating an appearance example of the logic chips 200 covered with the molding resin 470 according to the seventh embodiment of the present technology.
Fig. 25 is a view illustrating an arrangement example of the logic chips 200 on an image sensor chip 100 according to the seventh embodiment of the present technology.
Fig. 26 is a view illustrating an example of a method for manufacturing the semiconductor module according to the seventh embodiment of the present technology.
Fig. 27 is a view illustrating an example of a cross-sectional structure of a semiconductor module according to an eighth embodiment of the present technology.
Fig. 28 is a first view illustrating an example of a method for manufacturing the semiconductor module according to the eighth embodiment of the present technology.
Fig. 29 is a second view illustrating an example of the method for manufacturing the semiconductor module according to the eighth embodiment of the present technology.

### MODE FOR CARRYING OUT THE INVENTION

Hereinafter, modes for carrying out the present technology (hereinafter referred to as embodiments) will be described. The description will be given in the following order.
1. First Embodiment (structure example of covering logic chip with frame)
2. Second embodiment (structure example of filling with frame adhesive resin in sealed manner)
3. Third embodiment (structure example in which frame is brought into contact with upper surface of logic chip)
4. Fourth Embodiment (structure example of filling with frame adhesive resin in sealed manner)
5. Fifth Embodiment (structure example using sealing resin instead of frame)
6. Sixth embodiment (structure example using transparent resin instead of sealing glass)
7. Seventh Embodiment (first structure example in which logic chip is covered with molding resin)
8. Eighth embodiment (second structure example in which logic chip is covered with molding resin)

### <1. First embodiment>

### [Chip-on-chip structure]

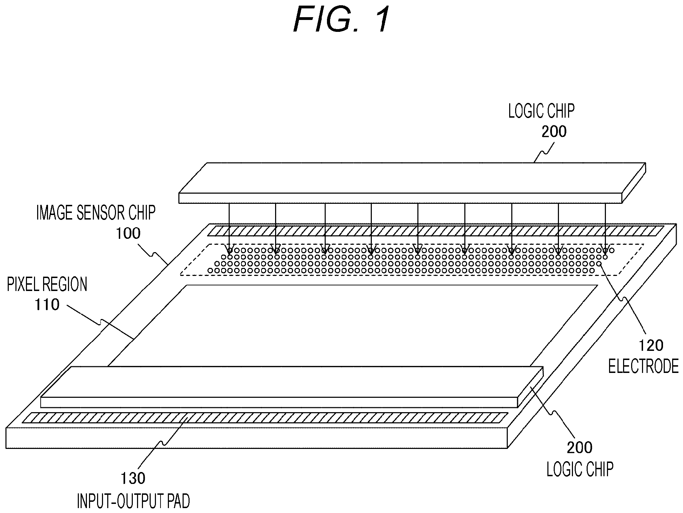

Fig. 1 is a view illustrating an example of a relationship between an image sensor chip 100 and logic chips 200 according to an embodiment of the present technology.

The image sensor chip 100 is a semiconductor element including an imaging element. The image sensor chip 100 includes a pixel region 110 of the imaging element on an upper surface, and photoelectrically converts incident light and generates a pixel signal on the basis of a signal charge generated according to the amount of received light. Note that the image sensor chip 100 is an example of a first semiconductor element described in the claims.

Furthermore, the logic chips 200 are arranged on an electrode 120 provided at a peripheral position different from the pixel region 110 on the upper surface of the image sensor chip 100. The logic chips 200 are semiconductor elements that perform signal processing such as correlated double sampling (CDS), signal amplification, and analog-to-digital (A/D) conversion on a pixel signal. Note that the logic chips 200 are an example of a second semiconductor element described in the claims.

The image sensor chip 100 and the logic chips 200 have a chip-on-chip (CoC) structure. That is, a structure in which the logic chips 200 are stacked on the upper surface of the image sensor chip 100 is provided. Note that, although the chip-on-chip structure is assumed in the following description, a chip-on-wafer (CoW) structure may be included. That is, instead of the image sensor chip 100, a silicon wafer including an imaging element may be provided, and the logic chips 200 may be formed thereon.

The image sensor chip 100 includes input-output pads 130 in a periphery. As described later, when the image sensor chip 100 is arranged on the circuit board, conduction wires (gold wires) are bonded from the input-output pads 130 to the circuit board.

### [Semiconductor module]

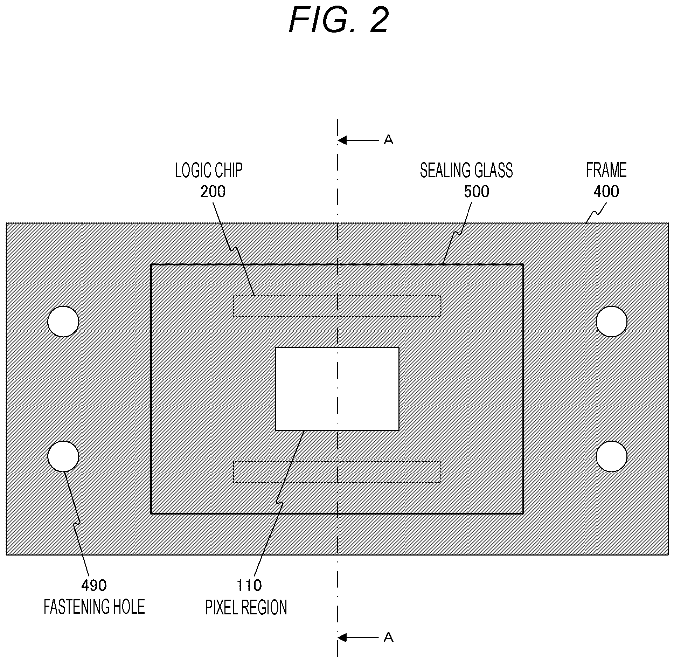

Fig. 2 is a view illustrating an example of a top view of the semiconductor module according to the embodiment of the present technology.

In this semiconductor module, the image sensor chip 100 and the logic chips 200 of the above-described chip-on-chip structure are arranged on a substrate, and a frame 400 is provided on an upper surface thereof. The frame 400 has a shape that covers the logic chips 200 in order to prevent flare and ghost due to reflected light from the logic chips 200. However, it is a structure in which the frame 400 includes an opening corresponding to the pixel region 110, and allows incident light to be incident on the pixel region 110. Note that the frame 400 may include fastening holes 490 for fixing the semiconductor module with screws. Note that the frame 400 is an example of a cover part described in the claims.

Furthermore, it is a structure in which a sealing glass 500 is provided on an upper surface of the frame 400, and is sealed by the sealing glass 500 in order to protect the imaging element from an external environment such as water, humidity, and external force.

Note that, in the following cross-sectional view, a cross-sectional structure in the A direction in the same drawing is illustrated.

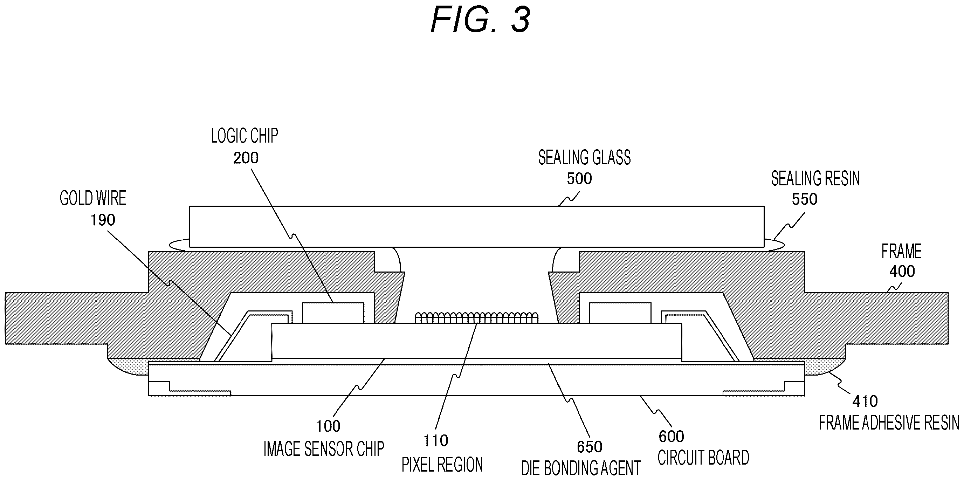

Fig. 3 is a view illustrating an example of a cross-sectional structure of the semiconductor module according to the first embodiment of the present technology.

The semiconductor module includes a flat circuit board 600. The material of the circuit board 600 may be a ceramic substrate, an organic substrate, or a flexible substrate. Note that the circuit board 600 is an example of a substrate described in the claims.

The image sensor chip 100 is bonded onto the circuit board 600 via a die bonding agent 650. The logic chips 200 are stacked on the upper surface of the image sensor chip 100 to form the chip-on-chip structure. Note that, here, the logic chips 200 which are active components have been described as an example of a component to be stacked on the image sensor chip 100, but passive components may be stacked.

On the upper surfaces of the image sensor chip 100 and the logic chips 200, the frame 400 covering them is formed. The frame 400 includes an opening on the upper surface of the pixel region 110, and allows incident light to be incident on the pixel region 110 while preventing the reflected light from the logic chips 200.

In order to prevent reflection of light rays, it is desirable to use a low-reflection black resin or the like for the frame 400. Furthermore, another resin such as an epoxy resin may be used as the material of the frame 400. In addition, metal such as stainless steel (SUS) or copper (Cu) may be used as the material of the frame 400.

The sealing glass 500 is bonded to the upper surface of the frame 400 via a sealing resin 550. The sealing glass 500 may include resin.

The input-output pads 130 of the image sensor chip 100 and electrodes of the circuit board 600 are electrically connected by gold wires 190.

The frame 400 and the circuit board 600 are bonded by a frame adhesive resin 410. In this embodiment, the frame 400 has a hollow structure and is not in contact with the logic chips 200 and the gold wires 190. Then, a region including the logic chips 200 and the gold wires 190 is an air blank region that is not sealed and filled.

### [Resin reservoir]

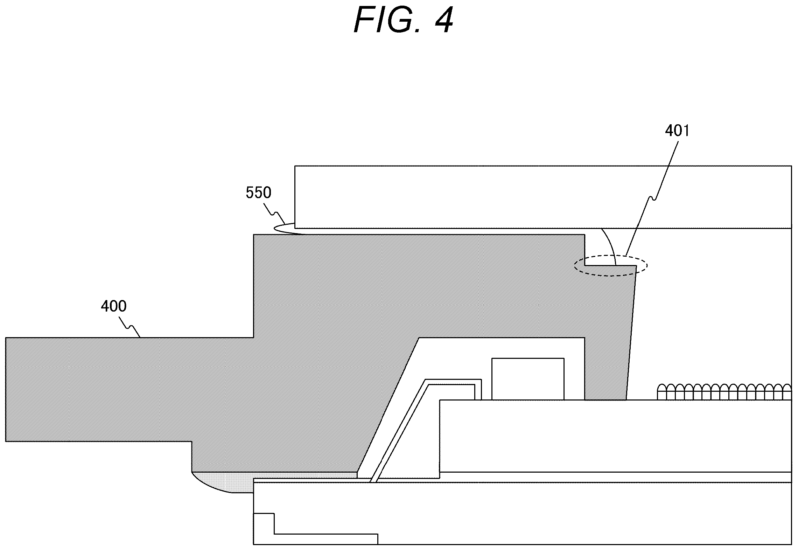

Fig. 4 is a view illustrating an example of a resin reservoir 401 of the frame 400 according to the first embodiment of the present technology.

As described above, the sealing resin 550 is used between the upper surface of the frame 400 and the sealing glass 500. At this time, there is a possibility that a part of the sealing resin 550 protrudes to the opening side of the pixel region 110 and reflects the light ray incident on the opening. Thus, it is desirable to form the resin reservoir 401. That is, a recessed portion (recess) is provided as the resin reservoir 401 in the inner wall distal end portion of the frame 400. Thus, it is possible to prevent the sealing resin 550 from protruding from the inner wall of the frame 400, and it is possible to prevent reflection of a light ray caused by the light ray hitting the sealing resin 550.

### [Embossing]

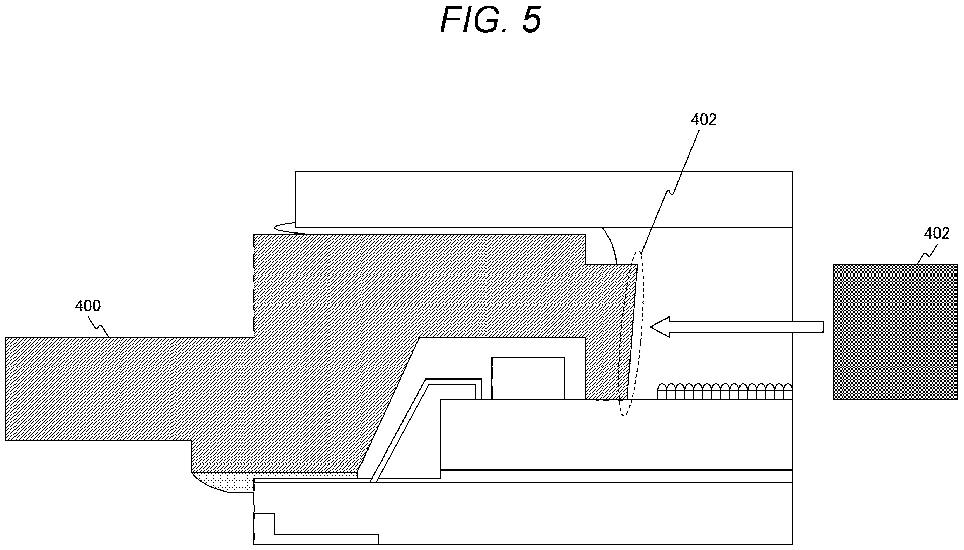

Fig. 5 is a view illustrating an example of embossing 402 of the inner wall of the frame 400 according to the first embodiment of the present technology.

In the opening of the frame 400, light reflected on the inner wall of the frame 400 may be incident on the pixel region 110 depending on the angle of the incident light ray, which may cause flare and ghost. Thus, it is desirable to perform the embossing 402 on the inner wall of the frame 400. That is, by forming a wrinkle pattern on the inner wall of the frame 400, it is possible to suppress the reflected light from being incident on the pixel region 110.

### [Tapered structure]

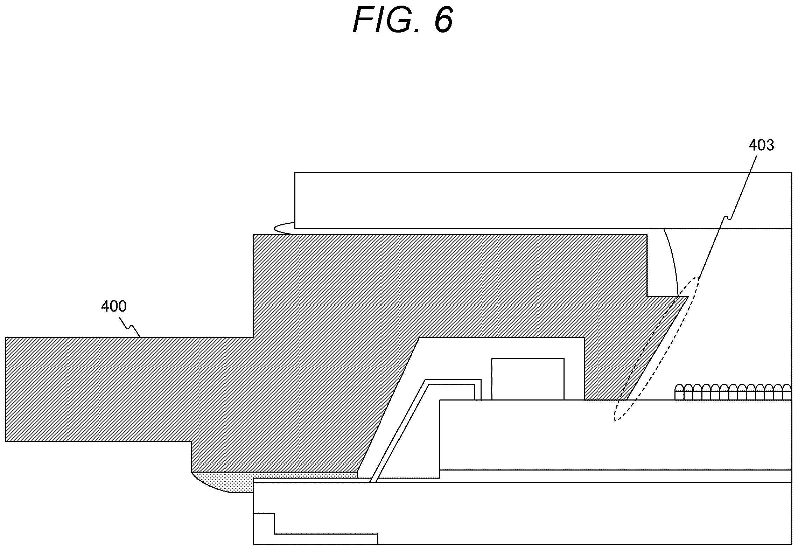

Fig. 6 is a view illustrating an example of the tapered structure 403 of the inner wall of the frame 400 according to the first embodiment of the present technology.

As described above, in the opening of the frame 400, depending on the angle of the incident light ray, the light reflected on the inner wall of the frame 400 may be incident on the pixel region 110 to cause flare and ghost. Thus, it is desirable to have a tapered structure in which the inner wall of the frame 400 is inclined toward the pixel region 110. That is, by inclining the angle of the inner wall of the frame 400 to, for example, 45 degrees or less with respect to the pixel surface, it is possible to suppress the reflected light from being incident on the pixel region 110.

As described above, according to the first embodiment of the present technology, by covering the upper surface with the frame 400 having the region including the logic chips 200 as an air blank region, incident light can be made incident on the pixel region 110 while preventing the reflected light from the logic chips 200.

### <2. Second embodiment>

### [Semiconductor module]

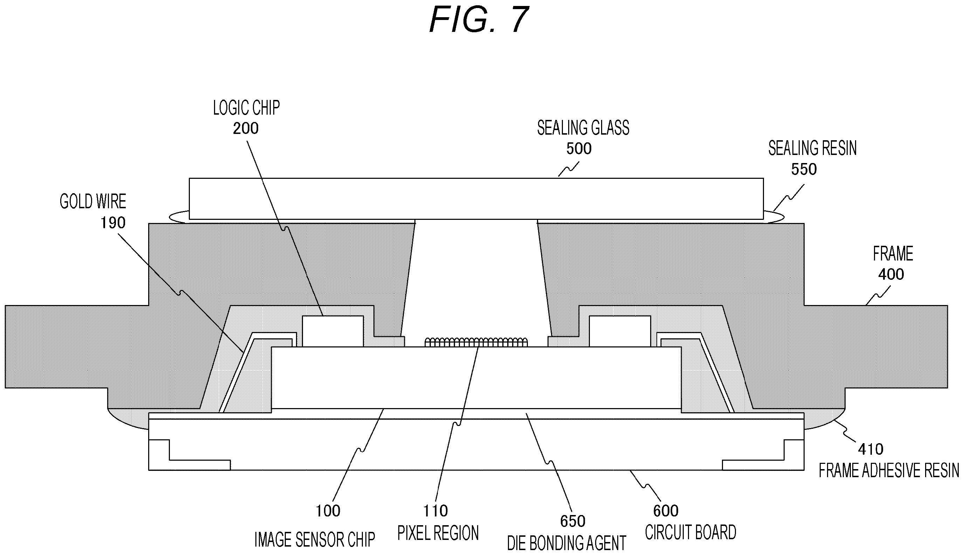

Fig. 7 is a view illustrating an example of a cross-sectional structure of a semiconductor module according to a second embodiment of the present technology.

In the first embodiment described above, the region including the logic chips 200 is an air blank region, but in the second embodiment, a structure is provided in which the region is filled with the frame adhesive resin 410 and sealed. That is, by filling and sealing the region including the logic chips 200 and the gold wires 190 with the frame adhesive resin 410, heat dissipation is promoted and adhesive strength is improved.

Note that it is similar to the first embodiment described above except that the frame adhesive resin 410 is filled in a sealed manner, and thus detailed description thereof will be omitted.

### [Manufacturing method]

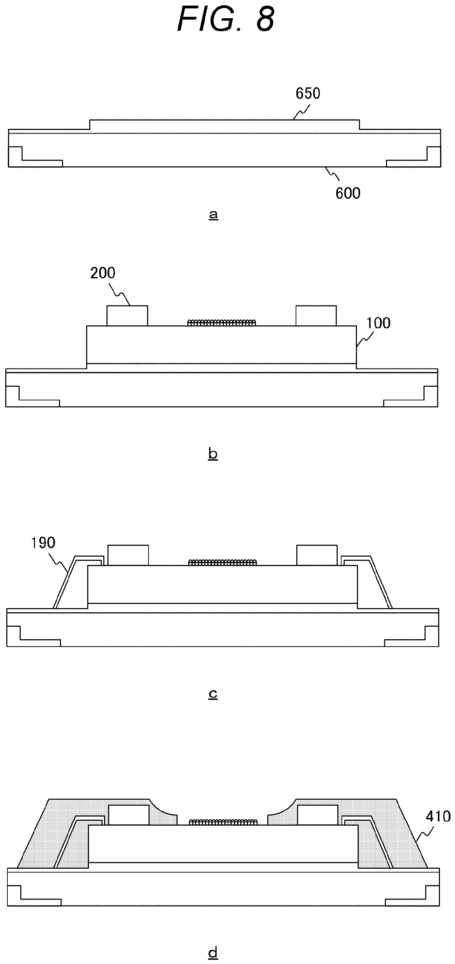

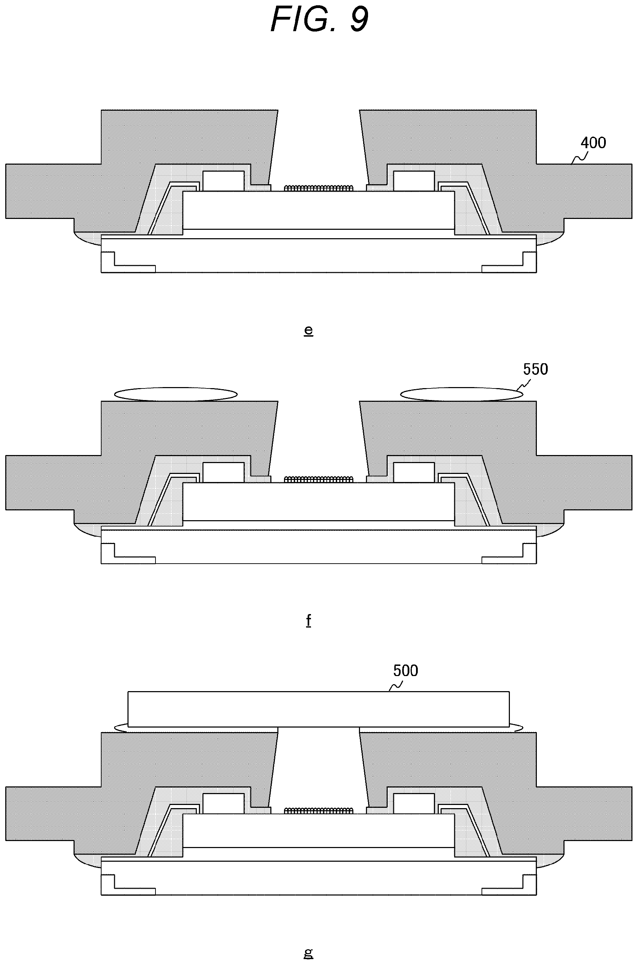

Figs. 8 and 9 are views illustrating an example of a method for manufacturing a semiconductor module according to the second embodiment of the present technology.

First, as illustrated in a in the same drawing, the die bonding agent 650 is applied to a package of the circuit board 600 of ceramic or the like. Then, as illustrated in b in the same drawing, the image sensor chip 100 and the logic chips 200 of the chip-on-chip structure are mounted, and the die bonding agent 650 is cured. Then, as illustrated in c in the same drawing, the input-output pads 130 of the image sensor chip 100 and the electrodes of the circuit board 600 are electrically connected by the gold wires 190.

Next, as illustrated in d in the same drawing, the frame adhesive resin 410 is applied. Then, as illustrated in e in the same drawing, the separately manufactured frame 400 is mounted on the circuit board 600 and cured. Note that, at that time, it may be mounted after the frame adhesive resin 410 is applied on the frame 400 side.

Next, as illustrated in f in the same drawing, the sealing resin 550 is applied to the upper surface of the frame 400. Then, as illustrated in g in the same drawing, the sealing resin 550 is cured after the sealing glass 500 is mounted thereon. Thus, the semiconductor module according to the second embodiment is manufactured.

As described above, according to the second embodiment of the present technology, by filling the region including the logic chips 200 with the frame adhesive resin 410 in a sealed manner and covering the region with the frame 400 from the upper surface, incident light can be made incident on the pixel region 110 while preventing the reflected light from the logic chips 200.

### <3. Third embodiment>

### [Semiconductor module]

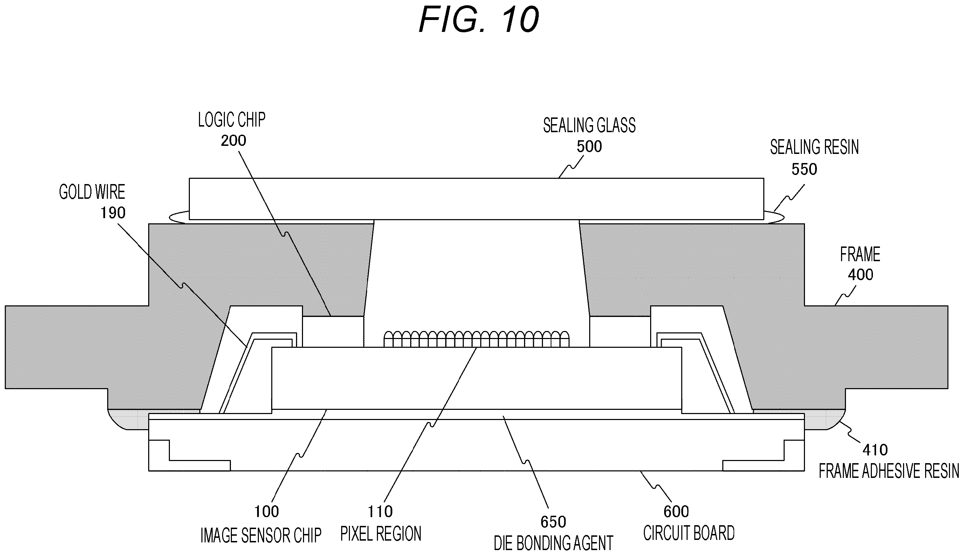

Fig. 10 is a view illustrating an example of a cross-sectional structure of a semiconductor module according to a third embodiment of the present technology.

The first embodiment described above has a structure in which the frame 400 is not in contact with the logic chips 200, but the third embodiment has a structure in which the frame 400 is in contact with the upper surface of the logic chips 200. That is, by blocking the upper surfaces of the logic chips 200 with the frame 400, the reflected light from the logic chips 200 is prevented so that light rays do not hit thereon.

The frame 400 is in contact with the upper surfaces of the logic chips 200, but the region including the gold wires 190 outside the logic chips 200 has a hollow structure and is an air blank region that is not filled in a sealed manner.

The structure of the frame 400 according to the third embodiment is advantageous in that it is easy to manufacture and is less likely to be damaged since it does not have a protruding portion as in the above-described first embodiment. Therefore, for example, in a case where the thicknesses of the logic chips 200 are thin and side surfaces have a small influence, the structure of the frame 400 of the third embodiment is advantageous. Furthermore, in general, the logic chips 200 tend to have a larger amount of heat generation than the image sensor chip 100, and thus it is advantageous to bring the frame 400 and the logic chips 200 into contact with each other as in the structure of the third embodiment because the number of heat generation paths increases.

As described above, according to the third embodiment of the present technology, the frame 400 contacts and blocks the upper surfaces of the logic chips 200, so that the incident light can be made incident on the pixel region 110 while preventing the reflected light from the logic chips 200.

### <4. Fourth embodiment>

### [Semiconductor module]

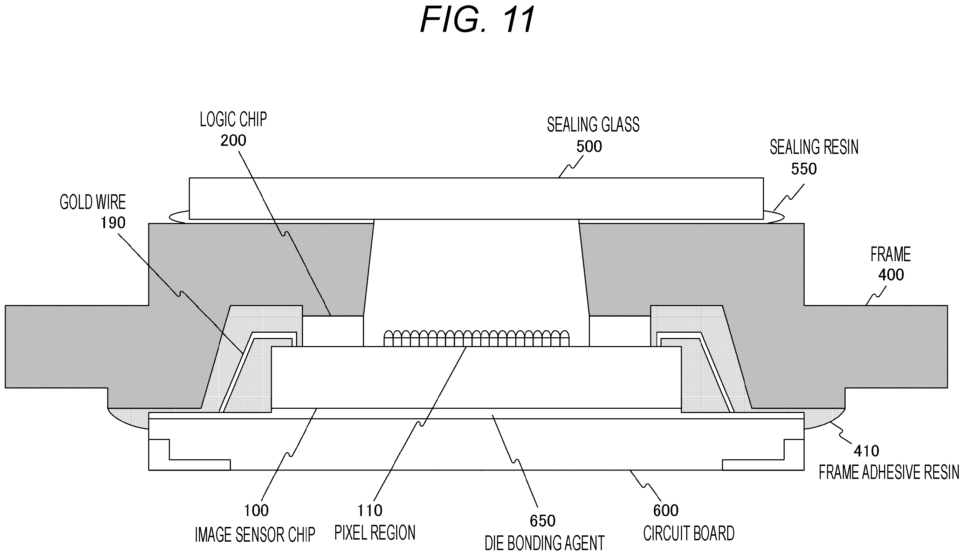

Fig. 11 is a view illustrating an example of a cross-sectional structure of a semiconductor module according to a fourth embodiment of the present technology.

In the third embodiment described above, the region including the gold wires 190 is an air blank region, but in the fourth embodiment, a structure is provided in which the region is filled and sealed with the frame adhesive resin 410. That is, by filling and sealing the region including the gold wires 190 with the frame adhesive resin 410, the heat dissipation is further promoted and the adhesion strength is improved. It is similar to the third embodiment described above except that the frame adhesive resin 410 is filled in a sealed manner, and thus detailed description thereof will be omitted.

### <5. Fifth embodiment>

### [Semiconductor module]

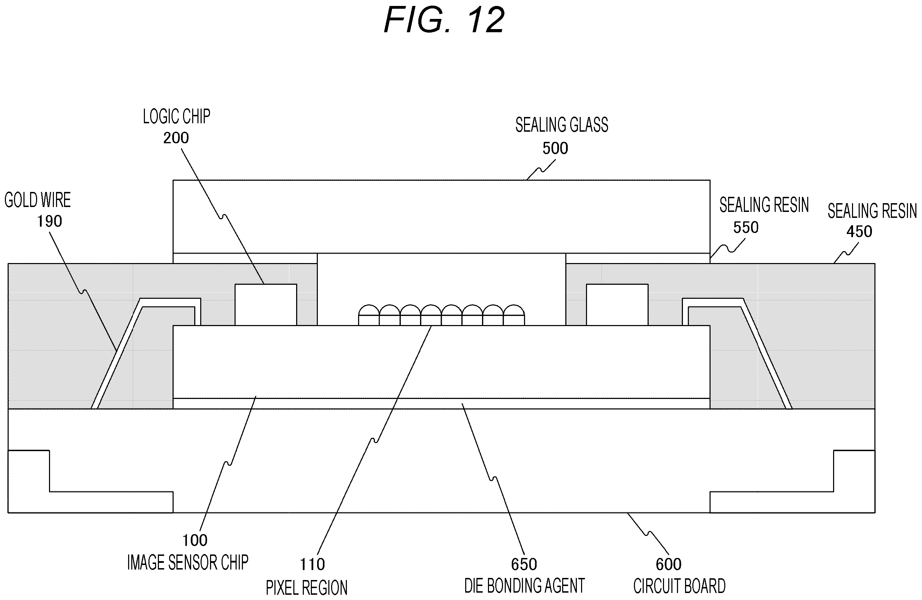

Fig. 12 is a view illustrating an example of a cross-sectional structure of a semiconductor module according to a fifth embodiment of the present technology.

The above-described embodiment has a structure in which the frame 400 manufactured separately is used, but the fifth embodiment has a structure in which the region including the logic chips 200 and the gold wires 190 is covered with a sealing resin 450 without using the frame 400. Thus, manufacturing is facilitated, and miniaturization and height reduction are achieved. Note that the sealing resin 450 is an example of a cover part described in the claims.

Note that it is similar to the above-described embodiment except that the frame 400 is covered with the sealing resin 450, and thus detailed description thereof will be omitted.

### [Manufacturing method]

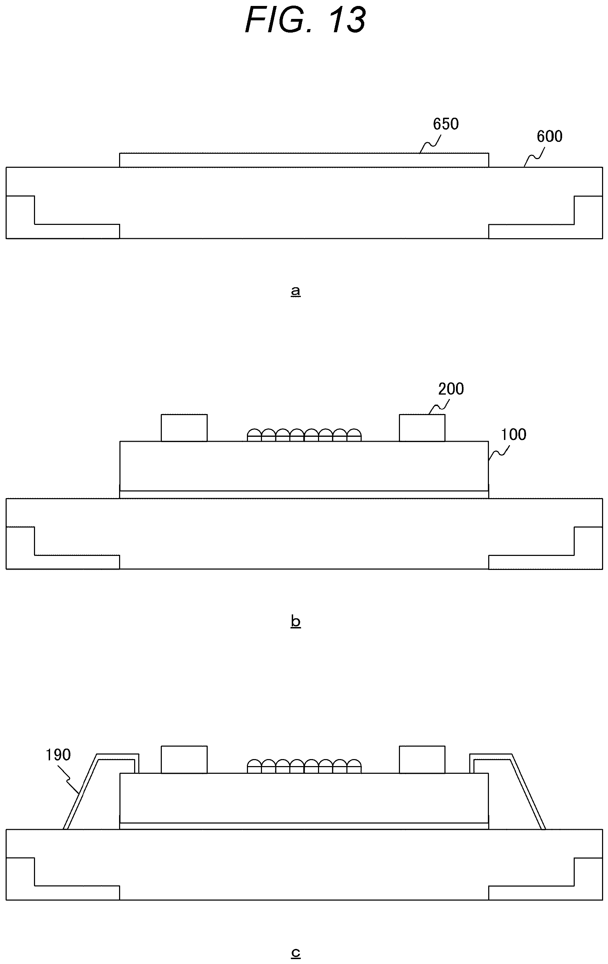

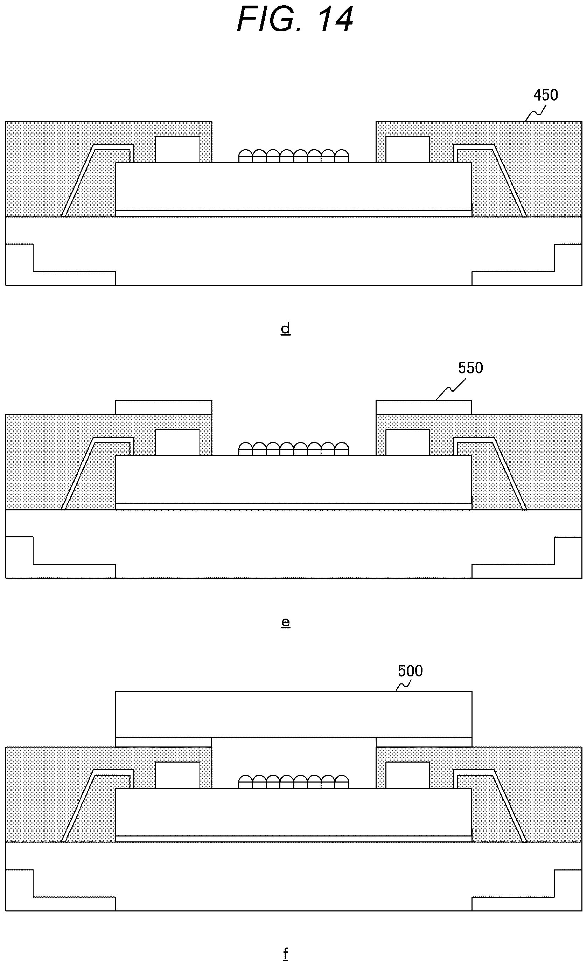

Figs. 13 and 14 are views illustrating an example of a method for manufacturing the semiconductor module according to the fifth embodiment of the present technology.

First, as illustrated in a in the same drawing, the die bonding agent 650 is applied to the package of the circuit board 600 of ceramic or the like. Then, as illustrated in b in the same drawing, the image sensor chip 100 and the logic chips 200 of the chip-on-chip structure are mounted, and the die bonding agent 650 is cured. Then, as illustrated in c in the same drawing, the input-output pads 130 of the image sensor chip 100 and the electrodes of the circuit board 600 are electrically connected by the gold wires 190.

Next, as illustrated in d in the same drawing, the logic chips 200 and the gold wires 190 are collectively covered with the sealing resin 450. At this time, for example, the sealing resin 450 is formed by a procedure in which the periphery is fitted into a mold and the material of the sealing resin 450 is poured into the mold.

Thereafter, the sealing resin 550 is applied to the upper surface of the sealing resin 450. Then, after the sealing glass 500 is mounted thereon, the sealing resin 550 is cured. Thus, the semiconductor module according to the fifth embodiment is manufactured.

As described above, according to the fifth embodiment of the present technology, by covering the region including the logic chips 200 with the sealing resin 450, incident light can be made incident on the pixel region 110 while preventing the reflected light from the logic chips 200.

### <6. Sixth embodiment>

### [Semiconductor module]

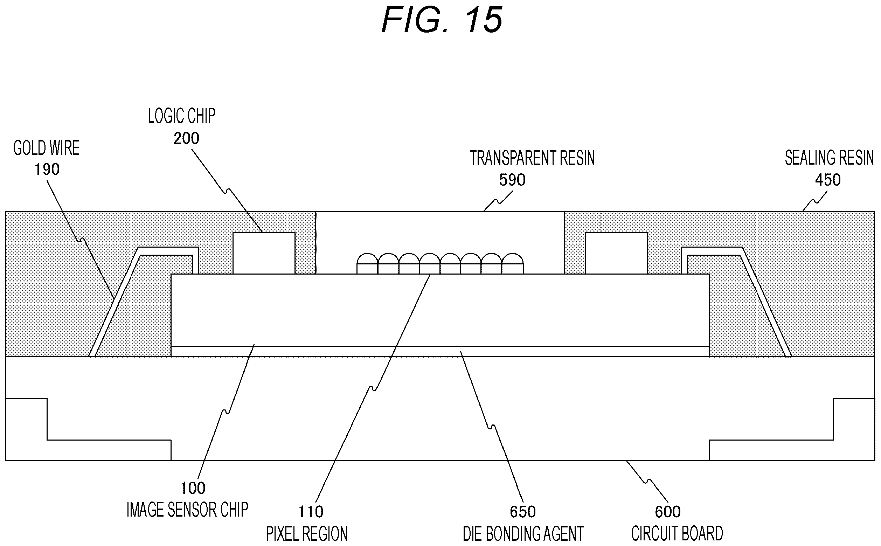

Fig. 15 is a view illustrating an example of a cross-sectional structure of a semiconductor module according to a sixth embodiment of the present technology.

The above-described fifth embodiment has a structure in which the sealing glass 500 is mounted on the upper surface of the sealing resin 450, but the sixth embodiment has a structure in which a transparent resin 590 is filled in the pixel region 110 instead of the sealing glass 500. That is, by not using the sealing glass 500, the height of the entire semiconductor module is reduced.

Note that it is similar to the fifth embodiment described above except that the transparent resin 590 is filled instead of the sealing glass 500, and thus detailed description thereof will be omitted.

### [Manufacturing method]

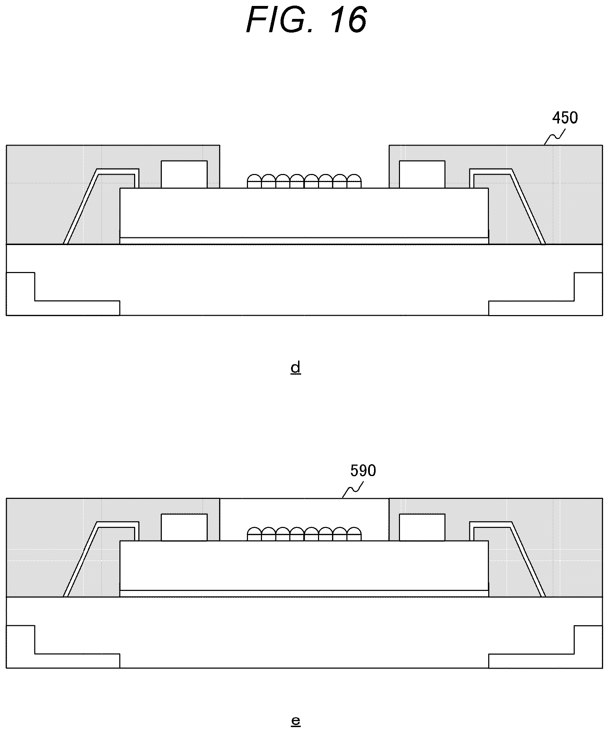

Fig. 16 is a view illustrating an example of a method for manufacturing the semiconductor module according to the sixth embodiment of the present technology.

Although not illustrated, the processes up to d in the same drawing are similar to those in the above-described fifth embodiment. As illustrated in e in the same drawing, the semiconductor module according to the sixth embodiment is manufactured by applying and curing the transparent resin 590 on the surface of the pixel in the pixel region 110.

As described above, according to the sixth embodiment of the present technology, by covering the region including the logic chips 200 with the sealing resin 450 and filling the pixel region 110 with the transparent resin 590, it is possible to reduce the height of the entire semiconductor module while preventing reflected light of the logic chips 200.

### <7. Seventh embodiment>

### [Semiconductor module]

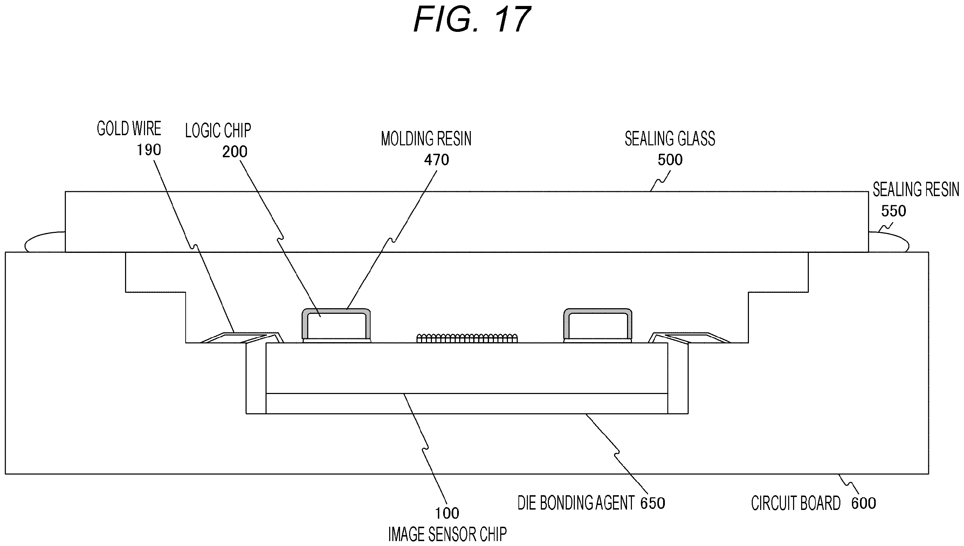

Fig. 17 is a view illustrating an example of a cross-sectional structure of a semiconductor module according to a seventh embodiment of the present technology.

In the above-described embodiment, the logic chips 200 are covered with the frame 400 and the sealing resin 450, but the seventh embodiment has a structure in which back surfaces and side surfaces of the logic chips 200 are covered with a molding resin 470. Thus, reflection from the back surfaces and the side surfaces of the logic chips 200 are prevented, and miniaturization and height reduction of the semiconductor module are achieved. Note that the molding resin 470 is an example of a cover part described in the claims.

In the semiconductor module according to the seventh embodiment, the image sensor chip 100 and the logic chips 200 of the chip-on-chip structure are mounted on the circuit board 600 via the die bonding agent 650. As the circuit board 600, for example, a ceramic package is assumed.

The sealing glass 500 is bonded to the upper surface of the circuit board 600 via the sealing resin 550. The sealing glass 500 does not need an anti-reflection coating (AR coating) or a light shielding film, and may be a normal sealing glass.

### [Manufacturing method]

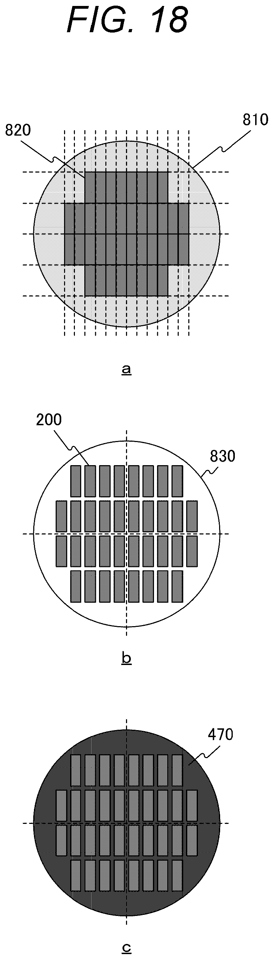

Fig. 18 is a view illustrating an example of a process of manufacturing the semiconductor module according to the seventh embodiment of the present technology.

As illustrated in a in the same drawing, logic chips 820 formed on a wafer 810 are cut out by dicing after microbumps are formed on the bonding surface.

Then, the cut individual logic chips 200 are arranged on the temporary arrangement sheet 830 as illustrated in b in the same drawing.

Thereafter, as illustrated in c in the same drawing, the molding resin 470 is formed on the back surfaces and the side surfaces of the logic chips 200.

These states are described in detail below.

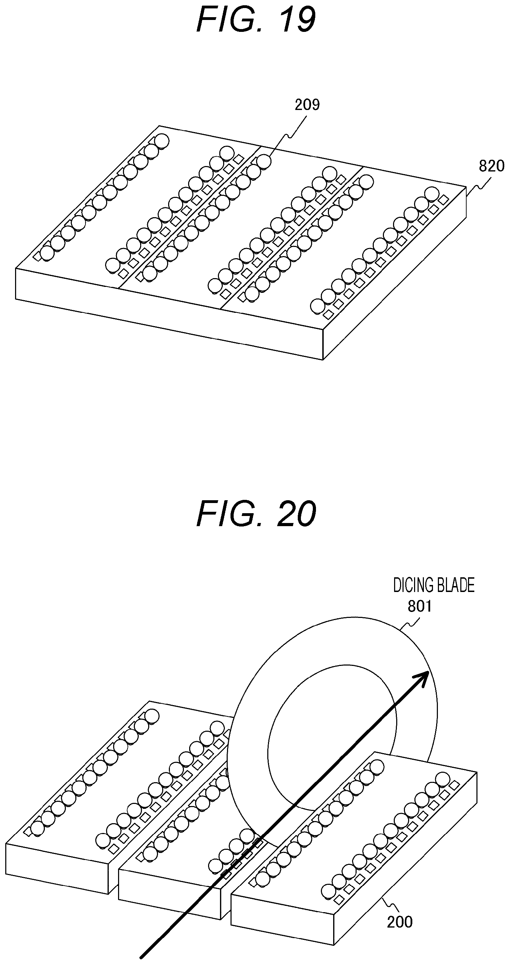

Fig. 19 is a view illustrating an appearance example of the logic chips 820 after microbumps 209 are formed according to the seventh embodiment of the present technology.

As described above, the microbumps 209 are formed on the logic chips 820 in a state of a wafer 800. The microbumps 209 are for connection with the image sensor chip 100. As a material of the microbumps 209, for example, a solder material such as tin (Sn), silver (Ag), or copper (Cu) is suitable. As a method for forming the microbumps 209, for example, a method such as electroplating, printing, or vapor deposition can be applied.

Fig. 20 is a view illustrating an example of how the logic chips 200 are singulated according to the seventh embodiment of the present technology.

As described above, the logic chips 820 formed on the wafer 800 are singulated into individual logic chips 200 by dicing. At the time of dicing, a normal dicing blade 801 for silicon can be used.

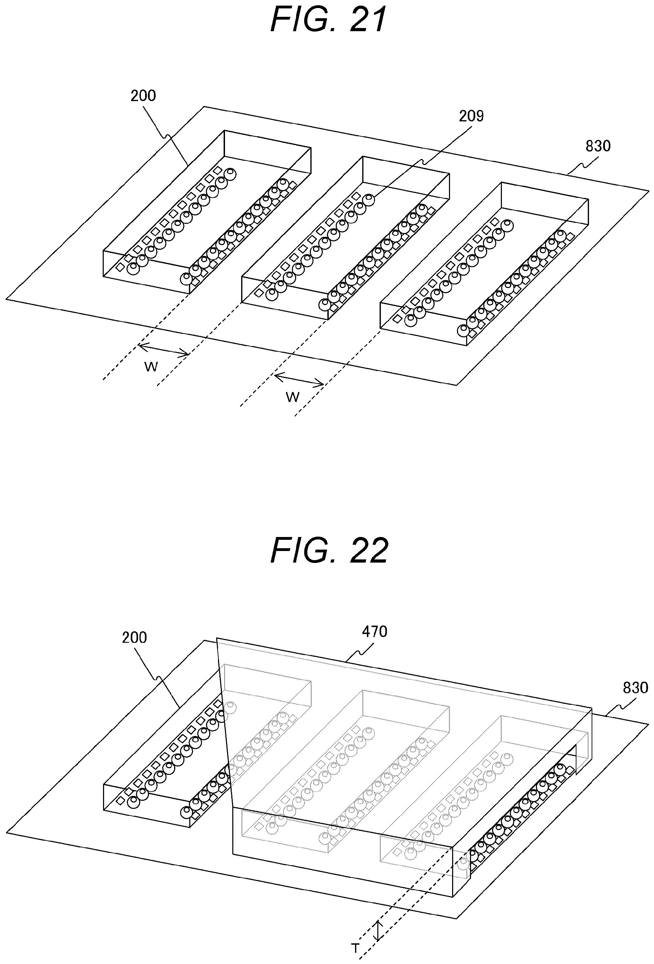

Fig. 21 is a view illustrating an example of a state of arrangement of the logic chips 200 on the temporary arrangement sheet 830 according to the seventh embodiment of the present technology.

As described above, the logic chips 200 are arranged on the temporary arrangement sheet 830 with formation surfaces for the microbumps 209 facing downward. As the temporary arrangement sheet 830, for example, a dicing sheet or the like can be used. However, the thickness of the bonding surface (for example, about 10 µm) is required so that the surfaces of the logic chips 200 including the microbumps 209 are completely hidden at the time of bonding.

Furthermore, it is necessary to arrange the logic chips 200 so that side walls of the logic chips 200 are completely hidden when the molding resin 470 is formed. A thickness of the molding resin 470 of a side wall can be adjusted by the interval W of the logic chips 200 at the time of this arrangement. That is, assuming that cutting is performed at the center of the interval W between the logic chips 200 by dicing in a subsequent process, the thickness of the molding resin 470 on the side surfaces of the logic chips 200 is "W/2".

Fig. 22 is a view illustrating an example of a state of forming the molding resin 470 according to the seventh embodiment of the present technology.

As described above, the molding resin 470 is formed on the back surfaces and the side surfaces of the logic chips 200. As a material of the molding resin 470, a material used in a fan-out chip size package (CSP) or the like is suitably used. Basically, it is an epoxy resin and contains a filler. When the filler is contained in the resin, minute irregularities are formed on the resin surface, so that what is called a "satin state" is obtained. It can be expected that the irregularities attenuate light applied to the surface of the molding resin 470. Thus, a further preventive effect against flare and ghost can be obtained. The particle size of the filler that provides such an effect is assumed to be, for example, about 5 to 50 µm. As such a material, specifically, a phenolic novolak resin, a biphenol type epoxy resin (BP-E.R.), an O-cresol novolak epoxy resin (OCN-E.R.), a trisphenol methane type epoxy resin (TPM-E.R.), a dicyclopentadiene type epoxy resin (DCPD-E.R.), and the like are assumed. Furthermore, the content ratio of the filler is desirably determined in consideration of the influence on fluidity.

A mold is used to form the molding resin 470, and a mold thickness T of the back surfaces of the logic chips 200 is determined by a cavity thickness of the mold. Furthermore, as the molding method, a compression molding method in which voids and the like are less likely to occur and resin fluidity is good is suitable.

Thus, the thickness of the molding resin 470 can be adjusted by "W/2" and "T". However, an optimum thickness varies depending on the transmittance of the resin, and thus the thickness is set according to physical properties of the resin so as to be a suitable thickness.

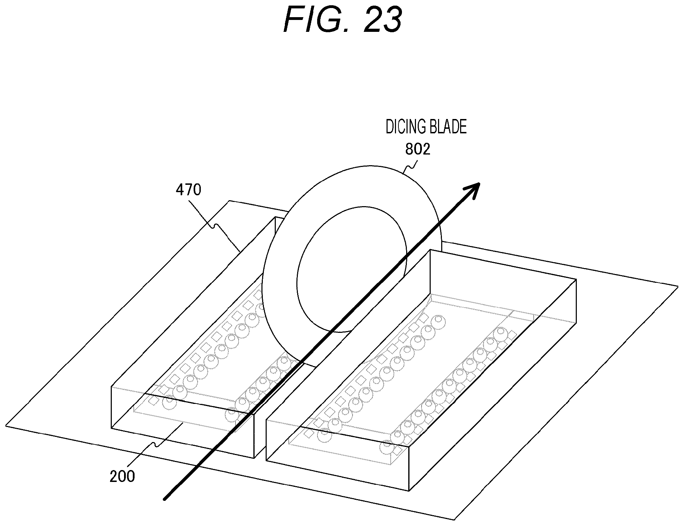

Fig. 23 is a view illustrating an example of how the logic chips 200 covered with the molding resin 470 are singulated according to the seventh embodiment of the present technology.

The logic chips 200 covered with the molding resin 470 are diced by dicing. At the time of dicing, a dicing blade 802 for resin used for dividing a BGA package or the like can be used.

The singulated logic chips 200 are peeled off from the temporary arrangement sheet 830. At this time, in a case where the adhesive remains on the formation surfaces for the microbumps 209, a cleaning step using a solvent that does not affect the molding resin 470 may be added.

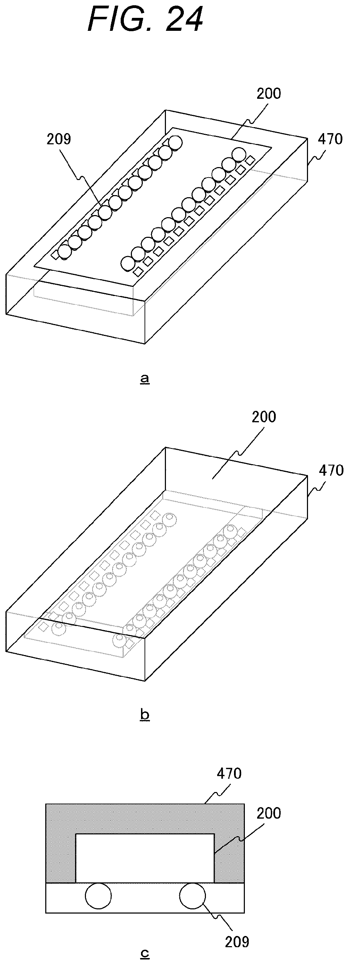

Fig. 24 is a view illustrating an appearance example of the logic chips 200 covered with the molding resin 470 according to the seventh embodiment of the present technology.

The logic chip 200 divided after the formation of the molding resin 470 is illustrated in the drawing. In the same drawing, a is a view as viewed from the surface on which the microbumps 209 are formed. In the same drawing, b is a view as viewed from the back surface of the logic chip 200. Furthermore, c in the same drawing is a cross-sectional view of the logic chip 200.

The logic chips 200 thus formed are arranged on the image sensor chip 100 as follows.

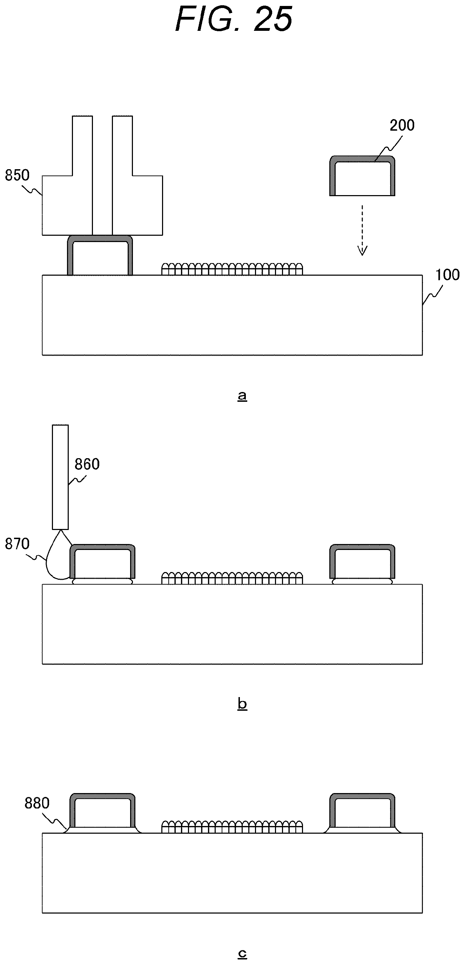

Fig. 25 is a view illustrating an arrangement example of the logic chips 200 on the image sensor chip 100 according to the seventh embodiment of the present technology.

As illustrated in a in the same drawing, the logic chips 200 covered with the molding resin 470 are mounted at positions different from the pixel region on the image sensor chip 100 by a collet 850.

Then, as illustrated in b in the same drawing, an underfill resin 870 is discharged from a dispenser nozzle 860 and applied. Thereafter, by curing the applied underfill resin 870, an underfill resin 880 is formed below the logic chips 200 as illustrated in c in the same drawing. At this time, the fillet of the underfill resin 880 is formed outside the molding resin 470.

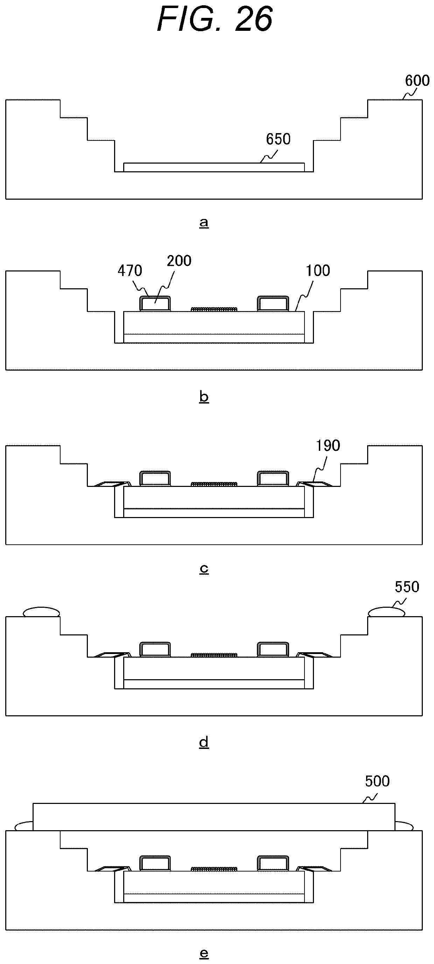

Fig. 26 is a view illustrating an example of a method for manufacturing the semiconductor module according to the seventh embodiment of the present technology.

The image sensor chip 100 and the logic chips 200 of the chip-on-chip structure manufactured as described above are mounted on the circuit board 600. Thus, as illustrated in a in the same drawing, the die bonding agent 650 is applied to the mounting position. Then, as illustrated in b in the same drawing, the image sensor chip 100 and the logic chips 200 of the chip-on-chip structure are mounted, and the die bonding agent 650 is cured. Then, as illustrated in c in the same drawing, the input-output pads of the image sensor chip 100 and the electrodes of the circuit board 600 are electrically connected by the gold wires 190.

Thereafter, as illustrated in d in the same drawing, the sealing resin 550 is applied to the upper surface of the circuit board 600. Then, after the sealing glass 500 is mounted thereon, the sealing resin 550 is cured. Thus, the semiconductor module according to the seventh embodiment is manufactured.

As described above, according to the seventh embodiment of the present technology, by covering the back surface and the side surfaces of the logic chips 200 with the molding resin 470, incident light can be made incident on the pixel region 110 while preventing the reflected light from the logic chips 200.

### <8. Eighth embodiment>

### [Semiconductor module]

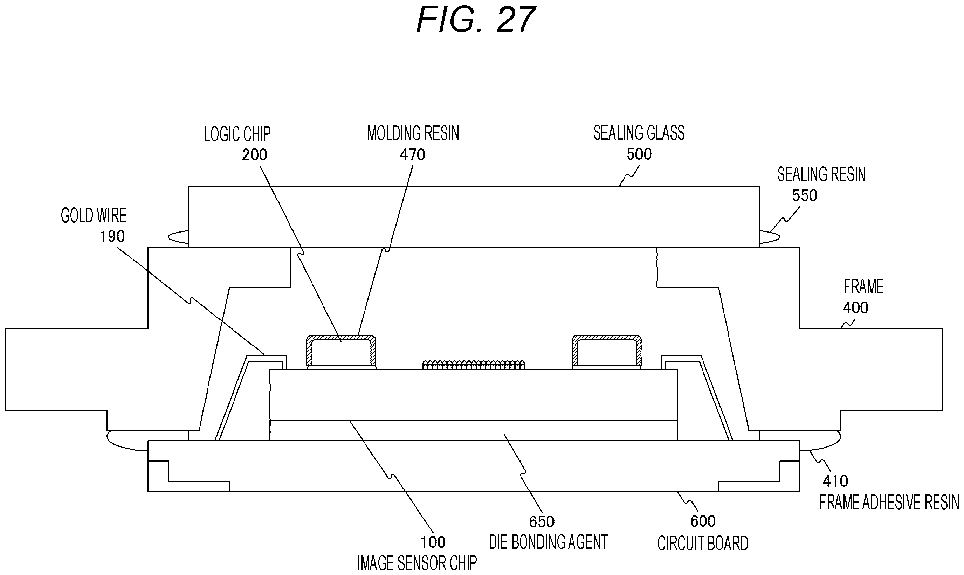

Fig. 27 is a view illustrating an example of a cross-sectional structure of a semiconductor module according to an eighth embodiment of the present technology.

The above-described seventh embodiment has a structure in which the sealing glass 500 is mounted on the upper surface of the circuit board 600, but the eighth embodiment has a structure in which the frame 400 is used as a package.

Note that the present embodiment is similar to the above-described seventh embodiment except that the frame 400 is used, and thus detailed description related to the structure is omitted.

### [Manufacturing method]

Also in the eighth embodiment, as in the above-described seventh embodiment, the image sensor chip 100 and the logic chips 200 of the chip-on-chip structure are used. The method for manufacturing the image sensor chip 100 and the logic chips 200 is similar to that of the above-described seventh embodiment, and thus detailed description thereof will be omitted.

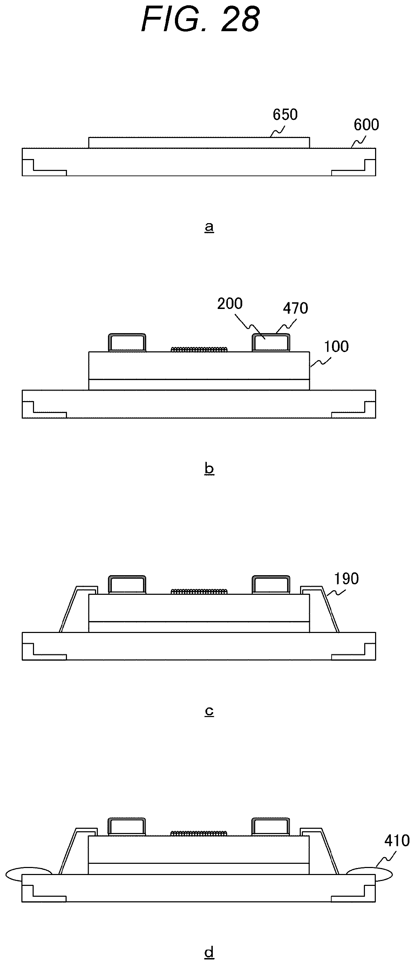

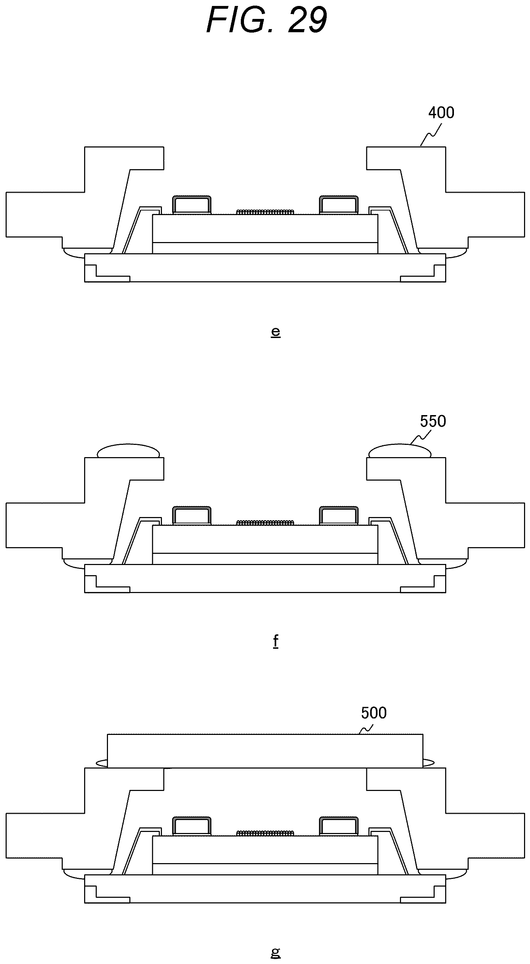

Figs. 28 and 29 are views illustrating an example of the method for manufacturing the semiconductor module according to the eighth embodiment of the present technology.

The image sensor chip 100 and the logic chips 200 of the chip-on-chip structure manufactured as described above are mounted on the circuit board 600. Thus, as illustrated in a in the same drawing, the die bonding agent 650 is applied to the mounting position. Then, as illustrated in b in the same drawing, the image sensor chip 100 and the logic chips 200 of the chip-on-chip structure are mounted, and the die bonding agent 650 is cured. Then, as illustrated in c in the same drawing, the input-output pads of the image sensor chip 100 and the electrodes of the circuit board 600 are electrically connected by the gold wires 190.

Next, as illustrated in d in the same drawing, the frame adhesive resin 410 is applied. Then, as illustrated in e in the same drawing, the separately manufactured frame 400 is mounted on the circuit board 600 and cured. Note that, at that time, it may be mounted after the frame adhesive resin 410 is applied on the frame 400 side.

Next, as illustrated in f in the same drawing, the sealing resin 550 is applied to the upper surface of the frame 400. Then, as illustrated in g in the same drawing, the sealing resin 550 is cured after the sealing glass 500 is mounted thereon. Thus, the semiconductor module according to the eighth embodiment is manufactured.

As described above, according to the eighth embodiment of the present technology, by covering the back surface and the side surface of the logic chips 200 with the molding resin 470, incident light can be made incident on the pixel region 110 while preventing the reflected light from the logic chips 200.

Note that the embodiments described above illustrate an example for embodying the present technology, and matters in the embodiments and matters specifying the invention in the claims have respective correspondence relationships. Similarly, the matters specifying the invention in the claims and matters having the same names in the embodiments of the present technology have respective correspondence relationships. However, the present technology is not limited to the embodiments and can be embodied by making various modifications to the embodiments without departing from the gist thereof.

Note that effects described in the present description are merely examples and are not limited, and other effects may be provided.

Note that the present technology can have configurations as follows.
(1) A semiconductor module, including:
   a substrate;
   a first semiconductor element arranged on the substrate and including a wiring electrically connected to the substrate and a pixel region of an imaging element on an upper surface opposite to a surface facing the substrate;
   a second semiconductor element arranged at a position different from the pixel region on the upper surface of the first semiconductor element; and
   a cover part that covers the first and second semiconductor elements from the upper surface with respect to at least a part of a region excluding the pixel region.
(2) The semiconductor module according to (1) above, in which
   the cover part is a frame having an opening corresponding to the pixel region and is attached to the substrate so as to cover the first and second semiconductor elements from the upper surface.
(3) The semiconductor module according to (2) above, in which
   the frame is formed by resin or metal.
(4) The semiconductor module according to (2) above, in which
   the frame has a hollow structure with respect to a region including the second semiconductor element and the wiring.
(5) The semiconductor module according to (4) above, further including a filling portion filled in a sealed manner in a region including the second semiconductor element and the wiring.
(6) The semiconductor module according to (5) above, in which
   the filling portion is formed by resin.
(7) The semiconductor module according to any one of (2) to (6) above, in which
   the frame is in contact with the upper surface of the second semiconductor element.
(8) The semiconductor module according to any one of (2) to (7) above, in which
   the frame is embossed on an inner wall facing the pixel region.
(9) The semiconductor module according to any one of (2) to (8) above, in which
   the frame has a tapered structure in which an inner wall facing the pixel region is inclined toward the pixel region.
(10) The semiconductor module according to any one of (2) to (9) above, further including a sealing glass bonded to an upper surface of the frame via a sealing material.
(11) The semiconductor module according to (10) above, in which
   the frame includes a recess in a region in contact with the sealing glass in an inner wall facing the pixel region.
(12) The semiconductor module according to (1) above, in which
   the cover part is a sealing resin that seals a portion other than an opening corresponding to the pixel region.
(13) The semiconductor module according to (12) above, further including a sealing glass bonded to an upper surface of the sealing resin via a sealing material.
(14) The semiconductor module according to (12) above, further including a transparent resin in the opening.
(15) The semiconductor module according to (1) above, in which
   the cover part is a molding resin that covers a back surface and a side surface of the second semiconductor element.
(16) The semiconductor module according to (15) above, in which
   the molding resin contains a filler.
(17) The semiconductor module according to (15) above, in which
   the second semiconductor element is bonded to the first semiconductor element via an underfill, and
   a fillet of the underfill is located outside the molding resin.
(18) The semiconductor module according to any one of (1) to (17) above, in which
   each of the first and second semiconductor elements is a semiconductor chip and forms a chip-on-chip structure.
(19) The semiconductor module according to any one of (1) to (17) above, in which
   the first semiconductor element is a semiconductor wafer,
   the second semiconductor element is a semiconductor chip, and
   the first and second semiconductor elements form a chip-on-wafer structure.
(20) A method for manufacturing a semiconductor module, the method including:
   a procedure of forming a second semiconductor element at a position different from a pixel region of an imaging element on an upper surface of a first semiconductor element including the pixel region;
   a procedure of mounting the first semiconductor element on a substrate and forming a wiring electrically connected to the substrate; and
   a procedure of forming a cover part that covers the first and second semiconductor elements from the upper surface with respect to at least a part of a region excluding the pixel region.

### REFERENCE SIGNS LIST

- 100: Image sensor chip
- 110: Pixel region
- 120: Electrode
- 130: Input-output pad
- 190: Gold wire
- 200: Logic chip
- 209: Microbump
- 400: Frame
- 402: Embossing
- 403: Tapered structure
- 410: Frame adhesive resin
- 450: Sealing resin
- 470: Molding resin
- 490: Fastening hole
- 500: Sealing glass
- 550: Sealing resin
- 590: Transparent resin
- 600: Circuit board
- 650: Die bonding agent
- 800: Wafer
- 801, 802: Dicing blade
- 810: Wafer
- 820: Logic chip
- 830: Temporary arrangement sheet
- 850: Collet
- 860: Dispenser nozzle
- 870, 880: Underfill resin

## Claims

1. A semiconductor module, comprising:
a substrate;
a first semiconductor element arranged on the substrate and including a wiring electrically connected to the substrate and a pixel region of an imaging element on an upper surface opposite to a surface facing the substrate;
a second semiconductor element arranged at a position different from the pixel region on the upper surface of the first semiconductor element; and
a cover part that covers the first and second semiconductor elements from the upper surface with respect to at least a part of a region excluding the pixel region.

2. The semiconductor module according to claim 1, wherein
the cover part is a frame having an opening corresponding to the pixel region and is attached to the substrate so as to cover the first and second semiconductor elements from the upper surface.

3. The semiconductor module according to claim 2, wherein
the frame is formed by resin or metal.

4. The semiconductor module according to claim 2, wherein
the frame has a hollow structure with respect to a region including the second semiconductor element and the wiring.

5. The semiconductor module according to claim 4, further comprising a filling portion filled in a sealed manner in a region including the second semiconductor element and the wiring.

6. The semiconductor module according to claim 5, wherein
the filling portion is formed by resin.

7. The semiconductor module according to claim 2, wherein
the frame is in contact with the upper surface of the second semiconductor element.

8. The semiconductor module according to claim 2, wherein
the frame is embossed on an inner wall facing the pixel region.

9. The semiconductor module according to claim 2, wherein
the frame has a tapered structure in which an inner wall facing the pixel region is inclined toward the pixel region.

10. The semiconductor module according to claim 2, further comprising a sealing glass bonded to an upper surface of the frame via a sealing material.

11. The semiconductor module according to claim 10, wherein
the frame includes a recess in a region in contact with the sealing glass in an inner wall facing the pixel region.

12. The semiconductor module according to claim 1, wherein
the cover part is a sealing resin that seals a portion other than an opening corresponding to the pixel region.

13. The semiconductor module according to claim 12, further comprising a sealing glass bonded to an upper surface of the sealing resin via a sealing material.

14. The semiconductor module according to claim 12, further comprising a transparent resin in the opening.

15. The semiconductor module according to claim 1, wherein
the cover part is a molding resin that covers a back surface and a side surface of the second semiconductor element.

16. The semiconductor module according to claim 15, wherein
the molding resin contains a filler.

17. The semiconductor module according to claim 15, wherein
the second semiconductor element is bonded to the first semiconductor element via an underfill, and
a fillet of the underfill is located outside the molding resin.

18. The semiconductor module according to claim 1, wherein
each of the first and second semiconductor elements is a semiconductor chip and forms a chip-on-chip structure.

19. The semiconductor module according to claim 1, wherein
the first semiconductor element is a semiconductor wafer,
the second semiconductor element is a semiconductor chip, and
the first and second semiconductor elements form a chip-on-wafer structure.

20. A method for manufacturing a semiconductor module, the method comprising:
a procedure of forming a second semiconductor element at a position different from a pixel region of an imaging element on an upper surface of a first semiconductor element including the pixel region;
a procedure of mounting the first semiconductor element on a substrate and forming a wiring electrically connected to the substrate; and
a procedure of forming a cover part that covers the first and second semiconductor elements from the upper surface with respect to at least a part of a region excluding the pixel region.
